# FASCICULE DE BREVET EUROPEEN

(11) **EP 2 042 467 B1**
(45) Date de publication et mention de la délivrance du brevet: **17.03.2010**
(21) Numéro de dépôt: 08354060.9
(22) Date de dépôt: 04.09.2008
(51) Int. Cl.: B81C 1/00, B01L 3/00

(54) **Procédé de fabrication d'un composant microfluidique comportant au moins un microcanal rempli de nanostructures**
Herstellungsverfahren einer Mikrofluid-Komponente, die mindestens einen mit Nanostrukturen gefüllten Mikrokanal umfasst
Method of manufacturing a microfluid component comprising at least one microchannel filled with nanostructures

(30) Priorité: 28.09.2007 FR 0706837
(43) Date de publication de la demande: 01.04.2009
(73) Titulaire: Commissariat A L'Energie Atomique - CEA, 75015 Paris (FR)
(72) Inventeur: Fonverne, Agnès, 38220 Vizille (FR); Dijon, Jean, 38800 Champagnier (FR); Ricoul, Florence, 38950 Quaix-en-Chartreuse (FR); Rouviere, Emmanuelle, 38120 Saint-Egrève (FR)
(74) Mandataire: Hecké, Gérard

(56) Documents cités:
- WO-A-2006/122697
- US-A1- 2004 096 992
- FONVERNE ET AL: "In situ synthesized carbon nanotubes as a new nanostructured stationary phase for microfabricated liquid chromatographic column" SENSORS AND ACTUATORS B, vol. 129, no. 2, 7 septembre 2007 (2007-09-07), pages 510-517, XP022479447 ELSEVIER SEQUOIA S.A., LAUSANNE, CH ISSN: 0925-4005

## Description

### Domaine technique de l'invention

L'invention concerne un procédé de fabrication d'un composant microfluidique comportant au moins un microcanal délimité par des parois inférieure et supérieure et deux parois latérales opposées, procédé comportant :
- la formation, dans une surface d'un substrat, de la paroi inférieure et des deux parois latérales opposées dudit microcanal,
- la formation, par croissance in situ à partir d'une couche de catalyseur métallique déposée sur les parois latérales opposées et sur la paroi inférieure dudit microcanal, de nanostructures remplissant ledit microcanal
- et la formation de la paroi supérieure dudit microcanal par mise en place d'un capot sur ladite surface du substrat et scellement dudit capot sur ladite surface.

### État de la technique

Les composants microfluidiques, également appelés microsystèmes fluidiques, tels que les microréacteurs ou bien les microlaboratoires plus connus sous les noms anglo-saxons de « µ-TAS » (micro Total Analysis System) ou de « Lab-on-a-chip », connaissent un réel essor depuis une dizaine d'années, pour réaliser des opérations et/ou des analyses chimiques ou biologiques, sur des échantillons de très petits volumes. L'utilisation de ces composants peut, en effet, permettre d'intégrer différentes étapes sur un même composant (injection, séparation, détection), limitant alors le nombre de connections et donc la perte des échantillons durant les différentes manipulations, tout en augmentant la sensibilité d'analyse et en diminuant la durée d'analyse.

Or, on cherche à intégrer un nombre croissant de fonctions dans ces composants microfluidiques. À titre d'exemple, il est souhaitable de réaliser des composants microfluidiques permettant de réaliser plusieurs opérations telles que des pré-traitements sur un échantillon, des filtrations, des mélanges, des séparations et/ou de la détection. Une telle intégration nécessite, cependant, des composants permettant d'obtenir des performances toujours plus grandes en termes de miniaturisation et/ou d'efficacité. De plus, il est connu que l'efficacité d'une réaction chimique ou biologique hétérogène ou d'une séparation est d'autant plus élevée que le rapport entre la surface du composant en contact avec l'échantillon et le volume d'échantillon circulant dans ledit composant, appelé également rapport S/V, est élevé.

Les approches les plus classiques pour obtenir un rapport S/V élevé consistent à remplir des microcanaux formés dans des composants microfluidiques par des structures poreuses ou phases stationnaires, telles que les billes de silice.

Ainsi, dans l'article « High performance liquid chromatography partially integrated onto a silicon chip » de Gregor Ocvirk et al. (Analytical Methods and Instrumentation, Vol 2, N°2, 74-82 (1995)), un système de chromatographie liquide est réalisé en formant un réseau de microcanaux, remplis d'un matériau de remplissage, dans une structure plane (ou puce) en silicium, avec un injecteur à débit divisé (« split injector ») disposé à l'entrée desdits microcanaux, ainsi qu'un fritté et une cellule de détection optique disposés à la sortie desdits microcanaux. Les microcanaux du système sont scellés par un procédé de type scellement anodique, à l'aide d'une couche en verre disposée sur la structure en silicium. Une autre structure en silicium, complétant le système, est scellée par le même procédé de scellement, sur la couche en verre, afin de rendre le système plus résistant.

Cependant, compte tenu du diamètre des microcanaux, remplir un microcanal de manière homogène avec une phase stationnaire devient une opération difficile à réaliser à l'échelle microscopique. De même, ces composants nécessitent la mise en place de systèmes retenant la phase stationnaire à l'intérieur des microcanaux, tels que des frittés ou des systèmes d'injection. Or, cette opération devient également délicate à cette échelle.

D'autres approches ont été envisagées pour remédier à ce problème. Il a, par exemple, été proposé de réaliser la phase stationnaire directement dans un microcanal. Ainsi, comme décrit dans l'article « Capillary columns with in situ formed porous monolithic packing for micro high-performance liquid chromatography and capillary electrochromatography » d'Isabelle Gusev et al. (Journal of Chromatography A, 855 (1999) 273-290), la synthèse in-situ d'une phase stationnaire monolithique ancrée sur les parois d'un microcanal permet d'éviter l'utilisation de frittés. Il a aussi été proposé d'utiliser les techniques utilisées dans le domaine de la microélectronique (photolithographie, gravure) pour former par nanostructuration et de façon reproductible et collective, une phase stationnaire à l'intérieur d'un microcanal.

Par ailleurs, les récents développements dans le domaine des procédés de synthèse de nanostructures, telles que les nanotubes de carbone également appelés NTC ou les nanofibres de carbone, permettent d'envisager de nouvelles perspectives pour développer la surface de contact des composants microfluidiques. Il existe principalement deux voies de développement.

La première voie consiste à réaliser, à partir de poudres catalytiques, des nanotubes de carbone indépendants, c'est-à-dire non solidaires d'une surface, puis à remplir le composant microfluidique et plus particulièrement le ou les microcanaux dudit composant, avec ces nanotubes de carbone préalablement synthétisés. Des cartouches d'extraction sur phase solide, mais également des colonnes de chromatographie ont ainsi été développées selon ce principe. À titre d'exemple, dans l'article « Electrophoretic separation of aniline derivatives using fused silica capillaries coated with acid treated single-walled carbon nanotubes » de John H.T. Luong et al., (Journal of Chromatography A, 1074 (2005) 187-194), la surface de capillaires en silice fondue est préparée, avant d'être revêtue par des nanotubes de carbone monofeuillets traités à l'acide. Le dépôt de nanotubes sur la surface des capillaires est réalisé en rinçant ladite surface par une solution contenant lesdits nanotubes préalablement synthétisés et traités.

La seconde voie permet de former les nanotubes de carbone in situ, sur une surface préalablement revêtue d'un dépôt de catalyseur métallique. La croissance des nanotubes peut, alors, être localisée précisément par un simple dépôt sélectif du catalyseur. Cette technique permet également d'éliminer toutes étapes de greffage ou de remplissage du microcanal. À titre d'exemple, Michael Stadermann et al. dans l'article « Ultrafast gas chromatography on single-wall carbon nanotube stationary phases in microfabricated channels » (Anal. Chem. 2006, 78, 5639-5644) décrivent une chromatographie en phase gazeuse ultrarapide sur des phases stationnaires formées par des nanotubes de carbone monofeuillets (SWNTs) dans des microcanaux microstructurés dans une plaquette en silicium. Lesdits nanotubes de carbone monofeuillets sont obtenus par croissance in situ, par dépôt chimique en phase vapeur, à partir d'une couche de catalyseur métallique, par exemple en aluminium, en molybdène ou en fer. De même, la demande WO-A-2006/122697 décrit un composant microfluidique comportant au moins un microcanal délimité dans un substrat et rempli de nanotubes synthétisés par croissance in situ à partir d'une couche de catalyseur métallique préalablement déposée sur les parois latérales opposées et sur la paroi inférieure dudit microcanal.

Avec cette seconde voie, les nanotubes de carbone sont, généralement, réalisés dans un microcanal sans paroi supérieure, c'est-à-dire un microcanal ouvert (ou rainure). Ceci permet de contrôler l'homogénéité du dépôt de la couche de catalyseur et la croissance des nanotubes. Dans la demande WO-A-2006/122697, un capot de protection est, ainsi, disposé, après la formation des nanotubes, sur la surface du substrat pour recouvrir ledit microcanal rempli de nanotubes. Le capot est, ensuite scellé par scellement moléculaire en formant des liaisons de type Si-Si ou de type Si-Verre, de qui rend le microcanal fermé et parfaitement étanche. De même, dans l'article de Michael Stadermann et al., les microcanaux sont fermés en déposant une couche en verre sur la plaquette en silicium et en réalisant un scellement anodique après la formation des nanotubes.

L'article de Fonverne et al. "In situ synthesized carbon nanotubes as a new nanostructured stationary phase for microfabricated liquid chromatographic column" paru dans SENSORS AND ACTUATORS B, vol. 129, no. 2, 7 septembre 2007 (2007-09-07), pages 510-517, Elsevier Sequoia S.A., Lausanne, décrit un procédé de fabrication d'un composant microfluidique qui comporte la croissance à partir d'une couche de nickel de nanostructures remplissant les microcanaux. A la fin du procédé, un capot est scellé sur la surface du substrat par liaison anodique.

Or, l'étape de scellement du capot, c'est-à-dire la fermeture du microcanal, se révèle être une étape critique dans le procédé de fabrication du composant microfluidique. En effet, le procédé de fabrication doit être compatible avec cette étape de scellement et notamment avec les contraintes qu'elle impose. En général, les nanotubes ne supportent pas les étapes préalables de nettoyage nécessaires pour réaliser le scellement entre deux plaquettes de silicium (« wafer-wafer »), ni les températures élevées sous conditions oxydantes de certaines techniques de scellement. De plus, les nanotubes risquent de polluer les surfaces assurant le scellement et/ou l'atmosphère des machines utilisées lors du procédé de fabrication.

Une méthode de croissance dans un milieu fermé a bien été proposée par Mahesh Karwa et al., dans l'article « Gas chromatography on self-assembled single-walled carbon nanotubes » ( Anal. Chem. 2006, 78, 2064-2070). Des nanotubes de carbone monofeuillets (SWNTs ou « Single-Walled Carbon Nanotubes ») sont formés dans un tube capillaire en acier inoxydable et dans un tube capillaire en acier inoxydable revêtu de silice, par synthèse catalytique en phase vapeur. Une solution éthanolique, dans laquelle est dissous de l'acétate de molybdène et du nitrate de cobalt hexahydraté, est injectée dans le tube capillaire, en même temps que de l'hydrogène, afin de revêtir le tube d'une couche en catalyseur. Puis, un dépôt chimique en phase vapeur (CVD) est réalisé pour former, par croissance in situ, des nanotubes. Comme le fer contenu dans les tubes capillaires agit comme un catalyseur pour la formation des nanotubes de carbone multifeuillets (MWNTs ou « Multi-Walled Carbon Nanotubes »)), le tube capillaire revêtu de silice est préféré pour réaliser les SWNTs.

Cependant, un tel procédé de fabrication et notamment le dépôt de catalyseur par l'intermédiaire d'une solution éthanolique n'est pas pratique à mettre en oeuvre, car il nécessite un nombre important de manipulations, et est difficilement adaptable en microsystème.

Pour éviter les contraintes liées au dépôt de catalyseur, Chutarat Saridara et Somenath Mitra ont proposé dans l'article « Chromatography on Self-Assembled Carbon Nanotubes » (Anal. Chem. 2005, 77, 7094-7097) d'utiliser le fer se trouvant dans les impuretés de l'acier inoxydable du tube capillaire comme catalyseur. Cependant, la formation des nanotubes de carbone s'avère inhomogène le long du tube capillaire.

### Objet de l'invention

L'invention a pour but un procédé de fabrication d'un composant microfluidique remédiant aux inconvénients mentionnés ci-dessus.

Plus particulièrement, l'invention a pour but un procédé de fabrication permettant d'obtenir, facilement et à faibles coûts, un composant microfluidique comportant au moins un microcanal rempli, de manière homogène, par des nanostructures. Le procédé doit, avantageusement, être compatible avec les procédés de réalisation de composants collectifs sur des plaquettes de type « wafer », tout en évitant de contaminer l'environnement du microcomposant.

Selon l'invention, ce but est atteint par les revendications annexées.

En particulier, ce but est atteint par le fait qu'une couche dudit catalyseur métallique est également déposée sur la surface du substrat destinée à venir en contact avec le capot et par le fait que le scellement est réalisé avant la formation des nanostructures, par traitement thermique formant un composé eutectique entre le métal de la couche de catalyseur métallique et un matériau du capot.

Selon un développement de l'invention, la couche dudit catalyseur métallique est déposée sur la surface du substrat destinée à venir en contact avec le capot en même temps que celle déposée sur les parois latérales opposées et sur la paroi inférieure dudit microcanal.

Selon un autre développement de l'invention, l'épaisseur de la couche dudit catalyseur métallique déposée sur la surface du substrat destinée à venir en contact avec le capot est comprise entre 20nm et 200nm.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 10 représentent, schématiquement et en coupe, différentes étapes successives d'un mode particulier de réalisation d'un procédé de fabrication selon l'invention.
- les figures 11 et 12 représentent, schématiquement et en coupe, des étapes d'une variante de réalisation du mode représenté sur les figures 1 à 10.

### Description de modes particuliers de réalisation

Un composant microfluidique, également appelé microsystème fluidique, comporte au moins un microcanal fermé permettant le passage d'un fluide. Ledit microcanal est délimité par des parois inférieure et supérieure et deux parois latérales opposées et il est rempli de nanostructures, telles que des nanotubes et en particulier des nanotubes de carbone.

Le composant est réalisé en formant, préalablement, dans une surface d'un substrat, par exemple en silicium, en oxyde de silicium ou en verre, la paroi inférieure et les deux parois latérales opposées dudit microcanal. La formation de la paroi supérieure dudit microcanal est réalisée en mettant en place un capot comportant, par exemple, un matériau choisi parmi le silicium, l'oxyde de silicium et le verre, sur ladite surface du substrat et en scellant le capot sur ladite surface. Puis, les nanostructures remplissant le microcanal sont formées par croissance in situ à partir d'une couche de catalyseur métallique déposée sur les parois latérales opposées et sur la paroi inférieure dudit microcanal.

Ainsi, contrairement aux procédés de fabrication décrits dans l'art antérieur et plus particulièrement le procédé décrit dans la demande de brevet WO-A-2006/122697, la paroi supérieure du microcanal est formée avant la formation des nanostructures. Plus particulièrement, une couche du même catalyseur métallique que celui utilisé pour la formation des nanostructures est également déposée sur le substrat. Ladite couche est, plus particulièrement, déposée sur la surface du substrat, destinée à venir en contact avec le capot. Le scellement est, alors, obtenu avant la formation des nanostructures, en réalisant un traitement thermique permettant de former un composé eutectique. Le composé eutectique est un composé eutectique entre le métal de la couche de catalyseur métallique et un matériau du capot ou avantageusement le matériau constituant ledit capot.

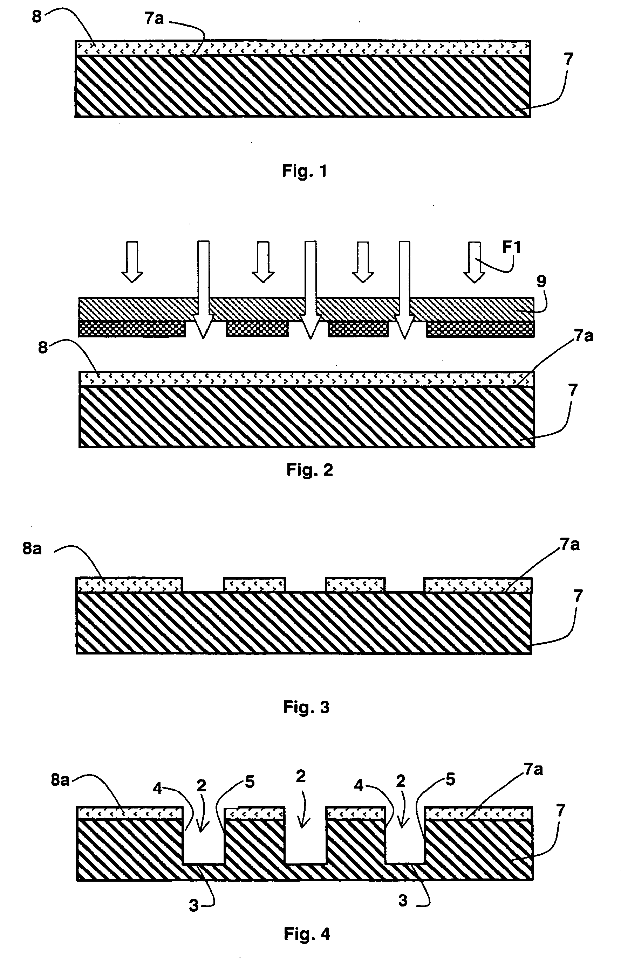

À titre d'exemple, les figures 1 à 10 illustrent un mode particulier de réalisation d'un composant microfluidique 1 comportant trois microcanaux 2 fermés. Par microcanal fermé, on entend un microcanal de dimensions microscopiques, comportant une entrée et une sortie pour le passage d'un fluide, mais délimité non seulement par une paroi inférieure 3 formant le fond du microcanal 2 et par deux parois latérales opposées 4 et 5 mais également par une paroi supérieure 6. Avantageusement, la distance P entre les parois inférieure 3 et supérieure 6 est comprise entre 5µm et 100µm tandis que la distance L entre les deux parois latérales 4 et 5 opposées est, de préférence, comprise entre 1 µm et 500µm.

La paroi inférieure 3 et les deux parois latérales opposées 4 et 5 de chaque microcanal 2 sont formées dans un substrat 7, par exemple dans une plaquette en silicium (« wafer ») d'une épaisseur de l'ordre de 450 micromètres et d'un diamètre de 100mm.

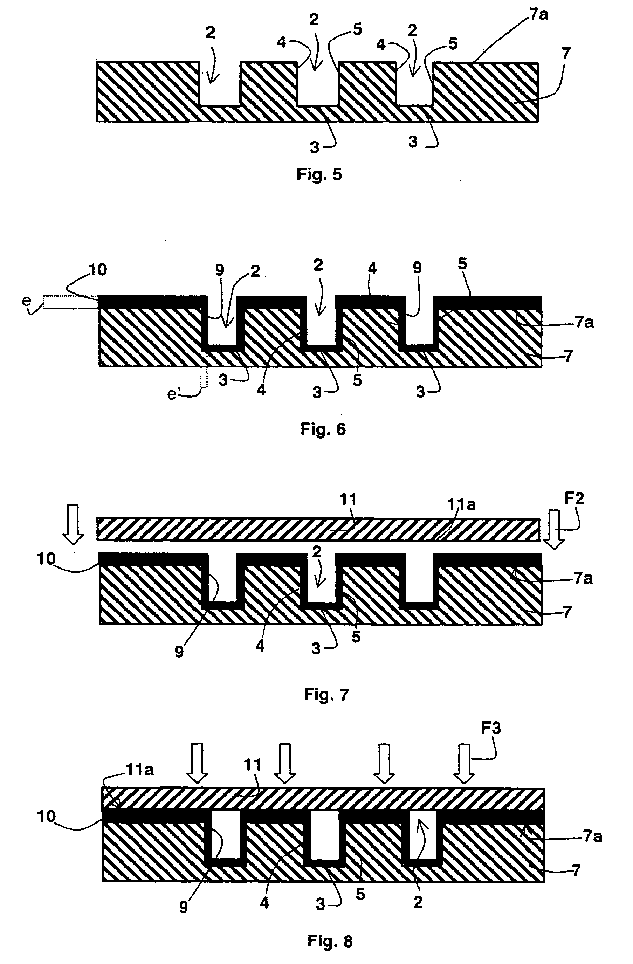

Ainsi, comme représentés sur les figures 1 à 5, les trois microcanaux 2 sont, par exemple, formés par gravure sélective dans un substrat 7 comportant une surface libre 7a. Pour réaliser la gravure sélective, la totalité de la surface libre 7a est, sur la figure 1, recouverte d'une couche 8 en résine photosensible. Puis, comme représenté sur les figures 2 et 3, la couche 8 est structurée sous forme de motifs 8a par photolithographie. Ainsi, les motifs 8a sont formés en insolant la couche 8 par rayonnements UV (flèches F1), à travers un masque 9, puis en éliminant les zones insolées de la couche 8. Ensuite, comme illustré sur la figure 4, le substrat 7 subit une étape de gravure profonde, par exemple par gravure ionique réactive profonde (DRIE ou "Deep Reactive Ion Etching"). L'étape de gravure est dite sélective, dans la mesure où la gravure du substrat 7 est réalisée uniquement au niveau des zones du substrat 7 non recouvertes par les motifs 8a. Ainsi, comme représenté sur la figure 5, elle permet de former, dans la surface 7a du substrat 7, des ouvertures (ou des rainures) délimitées, dans le substrat 7, par des surfaces formant les parois latérales 4 et 5 et la paroi inférieure 3 de chaque microcanal 2. Une fois le substrat 7 gravé, les motifs 8a de la couche photosensible sont éliminés, libérant, ainsi, la surface 7a du substrat 7 munie desdits microcanaux 2.

Comme représenté sur la figure 6, une étape de dépôt d'un catalyseur métallique est ensuite réalisée. Les parois latérales 4 et 5 et la paroi inférieure 3 de chaque microcanal 2 sont recouvertes d'une couche 9 en catalyseur métallique. De plus, la surface libre 7a du substrat 7 est également recouverte de catalyseur métallique. Une couche 10 constituée par le même catalyseur métallique recouvre donc ladite surface 7a. Elle est, avantageusement, déposée en même temps que la couche 9 recouvrant les parois latérales 4 et 5 et la paroi inférieure 3 des microcanaux.

Le métal formant le catalyseur métallique est, de préférence, choisi parmi le nickel, le cobalt, le fer et l'or et il peut être déposé par une technique de dépôt physique, par exemple par pulvérisation ou par évaporation, ou bien par une technique de dépôt chimique ou électrolytique. Selon la technique utilisée, les conditions de dépôt sont optimisées afin d'obtenir une couche de catalyseur métallique 10 sur la surface libre 7a du substrat 7, d'une épaisseur e suffisante pour réaliser l'étape ultérieure de scellement et une couche de catalyseur métallique 9 sur les parois latérales 4 et 5 d'une épaisseur e' compatible avec la croissance de nanostructures. L'épaisseur e de la couche de catalyseur métallique 10, déposée sur la surface libre 7a du substrat 7, est, de préférence, comprise entre 20nm et 200nm tandis que l'épaisseur e' de la couche de catalyseur métallique 9, déposée sur les parois latérales 4 et 5 est, avantageusement, comprise entre 1 nm et 20nm.

Ainsi, comme représenté sur les figures 7 à 9, la couche de catalyseur métallique 10 est, ensuite, utilisée, pour réaliser le scellement entre un capot de protection 11 et le substrat 7, avant la formation des nanostructures ( par exemple des nanotubes de carbone).

Le scellement est, donc, réalisé en formant un composé eutectique entre le métal de la couche en catalyseur métallique 10 et un matériau du capot 11. Le matériau du capot 11 est, avantageusement, choisi parmi le silicium, l'oxyde de silicium et le verre. Comme représenté sur la figure 7, le capot de protection 11 est mis en place ou disposé sur la couche 10 recouvrant la surface 7a du substrat 7 (flèches F2), de sorte que la face 11a du capot 11, avantageusement plane, entre en contact avec la surface 7a du substrat 7 et plus particulièrement avec la couche 10 disposée sur la surface 7a. Puis, comme illustré sur la figure 8, un traitement thermique (flèches F3) est réalisé à une température prédéterminée permettant d'obtenir la diffusion du métal contenu dans la couche 10 vers le capot 11 et la formation d'un composé eutectique 12 entre ledit métal et un matériau du capot. Ainsi, une fois le capot de protection 11 scellé sur le substrat 7, la face 11 a du capot 11 comporte des portions en contact avec la surface 7a et des portions disposées en regard des microcanaux 7. Lesdites portions de la face 11a disposées en regard des microcanaux 7 forment, alors, les parois supérieures 6 desdits microcanaux 2 et permettent donc de les fermer.

À titre d'exemple, pour une couche 10 en nickel et un capot 11 en silicium ou en oxyde de silicium, le scellement peut être obtenu en réalisant un traitement thermique permettant de former un siliciure de nickel. Une telle technique de scellement est, par exemple, connue pour sceller deux plaquettes en silicium par formation d'un siliciure de nickel à une température de traitement thermique de 440°C, comme le rapportent Zhi-Xiong Xiao et al. dans l'article « Low temperature silicon wafer-to-wafer bonding with nickel silicide » (J.Electrochem. Soc., Vol 145, N°4, April 1998).

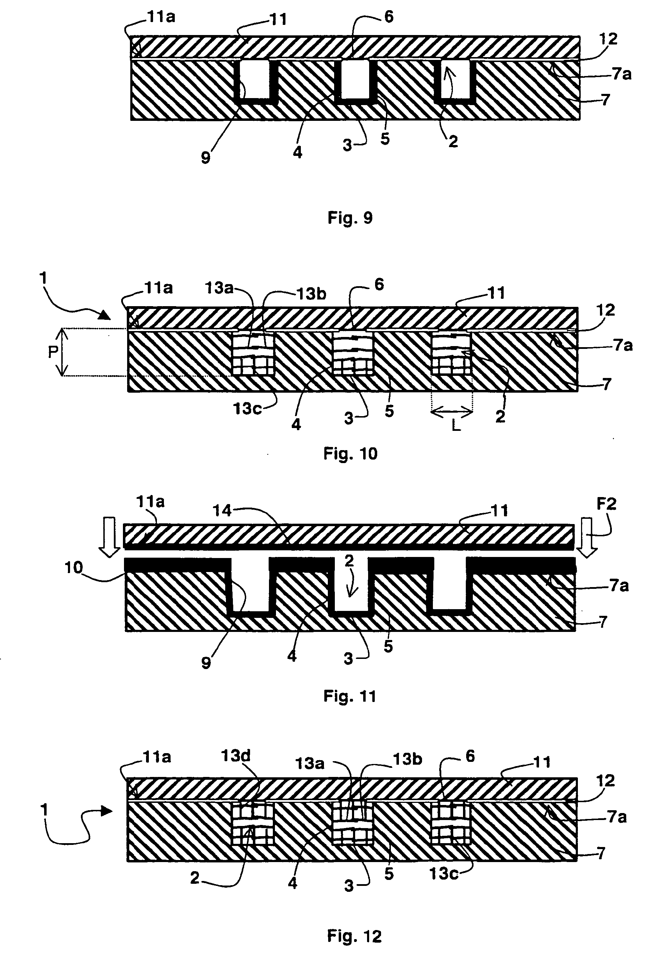

Dans le cadre de la présente invention, le métal utilisé pour réaliser le scellement sert également de catalyseur métallique pour réaliser la formation des nanostructures, dans les microcanaux 2. Ainsi, la couche de catalyseur métallique 9 déposée, sur la figure 6, sur les parois latérales 4 et 5 et sur la paroi inférieure 3 permet, ensuite, de catalyser la croissance des nanostructures telles que des nanotubes de carbone. Les nanotubes de carbone sont, par exemple, obtenus par dépôt chimique en phase vapeur (CVD) réalisé à une température de 700°C, sous pression atmosphérique et en utilisant de l'acétylène comme gaz carboné. Ainsi, dans un même cycle thermique, trois ensembles de nanostructures, respectivement 13a, 13b et 13c, sont formés sur la figure 10 par croissance, approximativement perpendiculairement aux parois respectives 4, 5 et 3. Il est, de plus, avantageusement, possible d'obtenir qu'une majorité des nanostructures 13a rejoigne les nanostructures 13b, comme représenté à la figure 10, de manière à remplir les microcanaux 2. Une étape ultérieure de découpe peut ensuite être réalisée pour former des microréacteurs munis chacun d'un ou de plusieurs microcanaux 2 complètement remplis de nanostructures.

Dans une variante de réalisation représentée sur les figures 11 et 12, une couche de catalyseur métallique supplémentaire 14 est déposée sur la totalité de la face 11 a du capot 11. La face 11 a du capot 11 est la face destinée à venir en contact avec la surface 7a du substrat 7, lors de la mise en place dudit capot sur la surface 7a du substrat 7. Ainsi, une fois le capot mis en place sur la surface 7a du substrat 7 et le scellement réalisé, les portions de la face 11 a disposées en regard des microcanaux 2 et formant les parois supérieures 6 desdits microcanaux 2 restent couvertes par du catalyseur métallique et peuvent donc être le siège d'une croissance in situ de nanostructures 13d, à partir de la couche de catalyseur métallique supplémentaire 14. Des nanostructures 13d sont alors formées sur la paroi supérieure 6 de chaque microcanal 2.

Le procédé de réalisation d'un composant microfluidique selon l'invention permet, ainsi, d'utiliser un métal jouant une double fonction :
- précurseur pour le scellement entre le capot et le substrat
- et catalyseur pour la croissance des nanostructures.
Ceci permet de diminuer le nombre d'étapes technologiques à réaliser et donc le coût de fabrication du composant, notamment par rapport au composant décrit dans la demande WO-A-2006/122697. En effet, dans la demande de brevet WO-A-2006/122697, lors de l'opération de dépôt du catalyseur métallique, une couche de catalyseur métallique est déposée sur les motifs restants de la couche en résine photosensible, afin d'être retirée avec lesdits motifs, avant la croissance de nanostructures et le scellement est réalisé après la croissance des nanostructures. Or, dans les modes de réalisation représentés sur les figures 1 à 12, le catalyseur métallique est déposé, après le retrait des motifs 8a, non seulement sur les parois 3, 4 et 5 des microcanaux 2, mais aussi la surface libre 7a du substrat 7 pour assurer le scellement du capot 11, avant la croissance des nanostructures.

Les microcanaux sont donc fermés avant la croissance de nanostructures. Cependant, avec un tel procédé de fabrication, la croissance des nanostructures, obtenue par croissance in situ, reste homogène, malgré la fermeture des microcanaux.

Enfin, un tel procédé est compatible avec un procédé de réalisation de composants collectif sur des plaquettes en silicium (« wafer ») et il ne nécessite pas d'étape technologique post-croissance, ce qui évite toute contamination éventuelle de l'environnement extérieur au composant, tel que les enceintes de dépôt et les salles blanches utilisées pour réaliser ces dépôts ou l'opérateur présent lors du procédé.

Un composant microfluidique obtenu par un tel procédé peut être utilisé dans diverses applications. À titre d'exemple, il peut être employé comme :
- support de décomposition catalytique : Si les parois des nanostructures sont recouvertes par un dépôt de platine, le microcomposant peut, par exemple, être utilisé pour réaliser l'oxydation complète du CO en CO₂ par l'oxygène à plus basse température.
- support de greffage d'enzyme : des nanotubes de carbone peuvent être facilement fonctionnalisés : les nanotubes peuvent être greffés par une enzyme telle que la trypsine afin d'utiliser le microcomposant pour la digestion de protéines,
- support de phase stationnaire : des nanotubes de carbone constituent une phase stationnaire directement utilisable pour des applications en chromatographie, ils peuvent également être fonctionnalisés par diverses molécules chimiques.

L'invention n'est pas limitée aux modes de réalisation représentés sur les figures 1 à 12. À titre d'exemple, le ou les microcanaux 2 du composant microfluidique peuvent avoir tout type de géométrie. De plus, leur entrée peut être connectée à une zone de division du fluide, elle-même connectée à un microcanal d'entrée tandis que leur sortie peut être connectée à une zone de rassemblement du fluide, elle-même connectée à un microcanal de sortie.

## Revendications

1. Procédé de fabrication d'un composant microfluidique (1) comportant au moins un microcanal (2) délimité par des parois inférieure (3) et supérieure (6) et deux parois latérales opposées (4, 5), procédé comportant :
- la formation, dans une surface (7a) d'un substrat (7), de la paroi inférieure (3) et des deux parois latérales (4, 5) opposées dudit microcanal (2),
- la formation, par croissance in situ à partir d'une couche de catalyseur métallique (9) déposée sur les parois latérales opposées (4, 5) et sur la paroi inférieure (3) dudit microcanal (2), de nanotstructures (13a, 13b, 13c) remplissant ledit microcanal (2)
- et la formation de la paroi supérieure (6) dudit microcanal (2) par mise en place d'un capot (11) sur ladite surface (7a) du substrat (7) et scellement dudit capot (11) sur ladite surface (7a),
procédé **caractérisé en ce qu'**une couche (10) dudit catalyseur métallique est également déposée sur la surface (7a) du substrat (7) destinée à venir en contact avec le capot (11) et **en ce que** le scellement est réalisé avant la formation des nanostructures (13a, 13b, 13c), par traitement thermique formant un composé eutectique (12) entre le métal de la couche de catalyseur métallique (10) et un matériau du capot (11).

2. Procédé selon la revendication 1, **caractérisé en ce que** la couche (10) dudit catalyseur métallique est déposée sur la surface (7a) du substrat (7) destinée à venir en contact avec le capot (11) en même temps que celle déposée sur les parois latérales opposées (4, 5) et sur la paroi inférieure (3) dudit microcanal (2).

3. Procédé selon l'une des revendications 1 et 2, **caractérisé en ce que** l'épaisseur (e) de la couche dudit catalyseur métallique (10) déposée sur la surface (7a) du substrat (7) destinée à venir en contact avec le capot (11) est comprise entre 20nm et 200nm.

4. Procédé selon l'une quelconque des revendications 1 à 3, **caractérisé en ce que** l'épaisseur (e') de la couche (9) déposée sur les parois latérales opposées et sur la paroi inférieure (3) dudit microcanal (2) est comprise entre 1 nm et 20nm.

5. Procédé selon l'une quelconque des revendications 1 à 4, **caractérisé en ce que** des nanostructures (13d) sont formées sur la paroi supérieure (6) du microcanal (2), par croissance in situ à partir d'une couche de catalyseur métallique supplémentaire (14) déposée sur ladite paroi (6).

6. Procédé selon la revendication 5, **caractérisé en ce que** la couche de catalyseur métallique supplémentaire (14) est déposée sur la totalité de la face (11a) du capot (11), destinée à venir en contact avec la surface (7a) du substrat (7) lors de la mise en place dudit capot (11).

7. Procédé selon l'une quelconque des revendications 1 à 6, **caractérisé en ce que** le catalyseur métallique est choisi parmi le nickel, le cobalt, le fer et l'or.

8. Procédé selon l'une quelconque des revendications 1 à 7, **caractérisé en ce que** le matériau du capot (11) est choisi parmi le silicium, l'oxyde de silicium et le verre.

9. Procédé selon l'une quelconque des revendications 1 à 8, **caractérisé en ce que** la distance (L) entre les deux parois latérales opposées (4, 5) du microcanal (2) est comprise entre 1µm et 500µm.

10. Procédé selon l'une quelconque des revendications 1 à 9, **caractérisé en ce que** la distance (P) entre les parois supérieure (6) et inférieure (3) du microcanal (2) est comprise entre 5µm et 100µm.

## Claims

1. A method for fabricating a microfluidic component (1) comprising at least a microchannel (2) delineated by bottom (3) and top (6) walls and two opposite side walls (4, 5), a method comprising:
- formation of the bottom wall (3) and of the two opposite side walls (4, 5) of said microchannel (2) in a surface (7a) of a substrate (7),
- formation of nanostructures (13a, 13b, 13c) filling said microchannel (2) by in situ growth from a metallic catalyst layer (9) deposited on the opposite side walls (4, 5) and on the bottom wall (3) of said microchannel (2),
- and formation of the top wall (6) of said microchannel (2) by positioning a cover (11) on said surface (7a) of the substrate (7) and sealing said cover (11) on said surface (7a),
a method **characterized in that** a layer (10) of said metallic catalyst is also deposited on the surface (7a) of the substrate (7) designed to come into contact with the cover (11) and **in that** sealing is performed before the nanostructures (13a, 13b, 13c) are formed by heat treatment forming an eutectic compound (12) between the metal of the metallic catalyst layer (10) and a material of the cover (11).

2. The method according to claim 1, **characterized in that** the layer (10) of said metallic catalyst is deposited on the surface (7a) of the substrate (7) designed to come into contact with the cover (11) at the same time as that deposited on the opposite side walls (4, 5) and on the bottom wall (3) of said microchannel (2).

3. The method according to one of claims 1 and 2, **characterized in that** the thickness (e) of the layer of said metallic catalyst (10) deposited on the surface (7a) of the substrate (7) designed to come into contact with the cover (11) is comprised between 20nm and 200nm.

4. The method according to any one of claims 1 to 3, **characterized in that** the thickness (e') of the layer (9) deposited on the opposite side walls and on the bottom wall (3) of said microchannel (2) is comprised between 1 nm and 20nm.

5. The method according to any one of claims 1 to 4, **characterized in that** nanostructures (13d) are formed on the top wall (6) of the microchannel (2) by in situ growth from an additional layer of metallic catalyst (14) deposited on said wall (6).

6. The method according to claim 5, **characterized in that** the additional layer of metallic catalyst (14) is deposited on the whole of the surface (11 a) of the cover (11), designed to come into contact with the surface (7a) of the substrate (7) when said cover (11) is positioned.

7. The method according to any one of claims 1 to 6, **characterized in that** the metallic catalyst is chosen from nickel, cobalt, iron and gold.

8. The method according to any one of claims 1 to 7, **characterized in that** the material of the cover (11) is chosen from silicon, silicon oxide and glass.

9. The method according to any one of claims 1 to 8, **characterized in that** the distance (L) between the two opposite side walls (4, 5) of the microchannel (2) is comprised between 1µm and 500µm.

10. The method according to any one of claims 1 to 9, **characterized in that** the distance (P) between the top wall (6) and bottom wall (3) of the microchannel (2) is comprised between 5µm and 100µm.

## Patentansprüche

1. Herstellungsverfahren für ein Mikrofluid-Bauteil (1), das mindestens einen Mikrokanal (2) umfasst, der von einer unteren Wand (3) und einer oberen Wand (6) und zwei einander gegenüberliegenden Seitenwänden (4, 5) begrenzt wird, Verfahren, das umfasst:
- das Ausbilden der unteren Wand (3) und der beiden gegenüberliegenden Seitenwände (4, 5) des Mikrokanals (2) in einer Oberfläche (7a) eines Substrats (7),
- die Bildung von Nanostrukturen (13a, 13b, 13c), die den Mikrokanal (2) füllen, durch Wachstum in situ ausgehend von einer Schicht aus einem metallischen Katalysator (9), die auf die gegenüberliegenden Seitenwände (4, 5) und auf die untere Wand (3) des Mikrokanals (2) aufgebracht wird,
- und das Ausbilden der oberen Wand (6) des genannten Mikrokanals (2) durch Anbringen einer Abdeckung (11) auf der genannten Oberfläche (7a) des Substrats (7) und festes Verbinden der Abdeckung (11) mit der genannten Oberfläche (7a),
Verfahren, das **dadurch gekennzeichnet ist, dass** eine Schicht (10) des genannten metallischen Katalysators auch auf die Oberfläche (7a) des Substrats (7) aufgebracht wird, die in Kontakt mit der Abdeckung (11) kommen soll, sowie dadurch, dass das feste Verbinden vor der Bildung der Nanostrukturen (13a, 13b, 13c) vorgenommen wird, und zwar durch Wärmebehandlung, bei der eine eutektische Verbindung (12) zwischen dem Metall der Schicht des metallischen Katalysators (10) und einem Material der Abdeckung (11) gebildet wird.

2. Verfahren nach Anspruch 1, **dadurch gekennzeichnet, dass** die Schicht (10) des metallischen Katalysators auf die Oberfläche (7a) des Substrats (7) aufgebracht wird, die mit der Abdeckung (11) in Kontakt kommen soll, und zwar gleichzeitig mit der Schicht, die auf die gegenüberliegenden Seitenwände (4, 5) und auf die untere Wand (3) des Mikrokanals (2) aufgebracht wird.

3. Verfahren nach einem der Ansprüche 1 und 2, **dadurch gekennzeichnet, dass** die Dicke (e) der Schicht des metallischen Katalysators (10), die auf die Oberfläche (7a) des Substrats (7) aufgebracht wird, die mit der Abdeckung (11) in Kontakt kommen soll, 20 bis 200 nm beträgt.

4. Verfahren nach einem der Ansprüche 1 bis 3, **dadurch gekennzeichnet, dass** die Dicke (e') der Schicht (9), die auf die gegenüberliegenden Seitenflächen und die untere Wand (3) des Mikrokanals (2) aufgebracht wird, 1 bis 20 nm beträgt.

5. Verfahren nach einem der Ansprüche 1 bis 4, **dadurch gekennzeichnet, dass** auf der oberen Wand (6) des Mikrokanals (2) Nanostrukturen (13d) gebildet werden, und zwar durch Wachstum in situ ausgehend von einer Schicht aus einem zusätzlichen metallischen Katalysator (14), die auf die genannte Wand (6) aufgebracht wird.

6. Verfahren nach Anspruch 5, **dadurch gekennzeichnet, dass** die Schicht aus einem zusätzlichen metallischen Katalysator (14) auf die gesamte Fläche (11a) der Abdeckung (11) aufgebracht wird, die beim Anbringen der Abdeckung (11) mit der Oberfläche (7a) des Substrats (7) in Kontakt kommen soll.

7. Verfahren nach einem der Ansprüche 1 bis 6, **dadurch gekennzeichnet, dass** der metallische Katalysator ausgewählt ist aus Nickel, Kobalt, Eisen und Gold.

8. Verfahren nach einem der Ansprüche 1 bis 7, **dadurch gekennzeichnet, dass** das Material der Abdeckung (11) aus Silizium, Siliziumoxid und Glas ausgewählt ist.

9. Verfahren nach einem der Ansprüche 1 bis 8, **dadurch gekennzeichnet, dass** der Abstand (L) zwischen den beiden gegenüberliegenden Seitenwänden (4, 5) des Mikrokanals (2) 1 bis 500 □m beträgt.

10. Verfahren nach einem der Ansprüche 1 bis 9, **dadurch gekennzeichnet, dass** der Abstand (P) zwischen der oberen Wand (6) und der unteren Wand (3) des Mikrokanals (2) 5 bis 100 □m beträgt.
